# EUROPEAN PATENT APPLICATION

(11) **EP 4 057 334 A1**
(43) Date of publication of application: **14.09.2022**
(21) Application number: 21161542.2
(22) Date of filing: 09.03.2021
(51) Int. Cl.: H01L 23/29, H01L 23/31, H01L 23/00

(54) **SEMICONDUCTOR POWER MODULE AND METHOD FOR MANUFACTURING A SEMICONDUCTOR POWER MODULE FOR A SEMICONDUCTOR DEVICE AND SEMICONDUCTOR DEVICE**

(71) Applicant: Hitachi Energy Switzerland AG, 5400 Baden (CH)
(72) Inventor: BEYER, Harald, 5600 Lenzburg (CH); GUILLON, David, 8857 Vorderthal (CH); EHRBAR, Roman, 8037 Zürich (CH)
(74) Representative: Epping - Hermann - Fischer

(57) **Abstract**

A semiconductor power module (10) comprises a substrate layer (11) forming a baseplate and a molded body coupled thereto. The molded body has at least one fiber and/or mesh structure forming a local reinforcement portion embedded in the molded body.

## Description

The present disclosure is related to a semiconductor power module for a semiconductor device and a corresponding semiconductor power device. The present disclosure is further related to a corresponding manufacturing method for a semiconductor power module.

Semiconductor power packages form technology for low, medium and high voltage applications which experience mechanical stress due to fixing to a cooler or during thermal cycling, for example. Thus, there is a risk causing voids or cracks in module encapsulation due to thermos-mechanical stress, for example. In this respect, it is a challenge generally to prevent damages.

Embodiments of the disclosure relate to a stable semiconductor power module with a reduced risk of damages occurring. Further embodiments of the disclosure relate to provide a corresponding semiconductor device and a manufacturing method for such a power module.

According to an embodiment, a semiconductor power module comprises a substrate layer forming a baseplate and a molded body coupled with the substrate layer. The molded body includes at least one fiber and/or mesh structure forming a local reinforcement portion embedded in the molded body.

By use of the described configuration a stable semiconductor power module with mechanically reinforced parts using fibers and/or a mesh is feasible at low cost. Thus, the semiconductor power module contributes to a reduced risk of damages occurring in sensitive positions of narrow walls or thinned portions or a portion exposed to enhanced stress, for example. The semiconductor power module can also be named semiconductor power package.

The substrate layer can realize a single layer or can comprise more substrates or a baseplate with substrates. The substrate layer can also realize a lead frame for supporting the molded body. The substrate layer can also realize a portion of the molded body integrally formed with it in one piece. The term "embedded" means or can also be interpreted in a way that there is a fiber and/or mesh structure impregnated or covered with a compound of the molded body. The fiber and/or mesh structure can also be embedded in the sense of being completely enclosed in the molded body. Alternatively, the fiber and/or mesh structure can be embedded in part. Alternatively or additionally, mold compound may initially contain fibers.

It is a recognition in the context of the present disclosure that with respect to conventional packages a package body is assembled together with a stiff substrate or baseplate with substrates to provide sufficient mechanical stability, for example. Nevertheless, in view of molded packages typical sizes of conventional bodies relative smaller. Moreover, conventional molded modules comprise standard molding compounds with a high degree of filler, for example filled by 80-90% silica particles for an adjustment of the thermal expansion coefficient and for a desired dielectric behaviour. Such a high degree of filler content makes the molding compound brittle with respect to the mechanical behaviour. The described reinforced semiconductor power module enables to counteract mechanical instabilities and even allows for it is application in large power packages, with an edge length of 50 mm or more up to 100 mm for example, with sufficient and reliable stability. For instances, the described semiconductor power package can be even suitable for a molded body size of 100 x 140 mm² for large substrate application, for example. Such a large size makes a body of a power module much more sensitive with respect to mechanical stress, e.g. caused by bending when screwing down power module to a cooler or during thermal cycling. Due to the one or more local reinforcement portions each enclosing a fiber and/or mesh structure embedded in the molded body the semiconductor power package can withstand the aforementioned stress effects even with such large dimensions. Thus, cracks in the molded body especially on mechanically critical positions can be prevented.

It is a further recognition in the context of the present disclosure that mechanically critical positions occurs on one hand in a vicinity of openings of terminals, which realize weak points of a package design, and on the other hand in areas next to a screw fitting or above a chip, for example. Thus, according to an embodiment of the semiconductor power package the molded body comprises an opening, a recess, a thinned area and/or a narrow wall structure and the at least one local reinforcement portion is formed adjacent to the opening, the recess and/or the narrow wall structure. Due to such a configuration of reinforcing the mechanically critical positions it is possible to achieve sufficient mechanical stability of all parts of the molded body exposed to mechanical stress, e.g. next to screwed connections.

The aforementioned thinned area denotes a wall, a side, a top and/or a bottom portion with a smaller wall thickness compared to a respective adjacent portion of the molded body, for example. Compared to thicker portions of the molded body the narrow wall structure can also represent a relative thin wall at an edge or between two recesses of the molded body, for example, which might be a portion of the molded body exposed to enhanced stress due to an intended arrangement. Thus, such thin areas beneficially comprise a respective reinforcement.

According to a further embodiment of the semiconductor power package the molded body comprises a first molding compound and a second molding compound different from the first one. The first molding compound is configured to form a first molded body portion without local reinforcement and the second molding compound includes the at least one fiber and/or mesh structure and is configured to form a second molded body portion with local reinforcement. Thus, a semiconductor power package comprising at least two different molding compounds is feasible to enable a mechanically stable and reliable structure.

The second molding compound can comprises glass and/or carbon fibers. For example, the first and second molding compounds differs from each other with respect to a respective filler and/or resin material. Moreover, the first and second molding compounds and the corresponding first and second molded body portions can be formed to overlap each other in part at least with respect to a lateral direction. Alternatively or additionally, portions of the different molding compounds can be arranged side-by-side.

Alternatively or additionally to the aforementioned reinforcing second molding compound the molded body can comprise a separate reinforcement part including the at least one fiber and/or mesh structure forming a molded body portion with local reinforcement. The separate reinforcement part can comprise glass and/or carbon fibers. According to an embodiment of the semiconductor power package, the separate reinforcement part comprises a metal mesh. Alternatively or additionally, the separate reinforcement part comprises a non-conductive mesh.

Moreover, the semiconductor power package can further comprise an electronic unit, for example a chip, a processing unit and/or an integrated circuit, which is coupled with the substrate layer and embedded in the local reinforcement portion or covered by it.

The described embodiments realize possible configurations of the semiconductor power package which each comprise at least one local improvement of the mechanical stability of the molded body due to fibers or by an element made of mesh or fibers. The molded body can realize a relative large package body formed by means of transfer molding, for example. The reinforcing structures can be specifically incorporated basing on the local use of fiber reinforced molding compound and/or basing on the implementation of a mesh or fibrous element which is arranged respectively at mechanically critical regions of the molded body.

In view of the reinforcing second molding compound an epoxy molding compound can be used, which comprises a certain amount of fibers like glass fibers or carbon fibers. Consequently, the molded body comprises two different molding compounds, wherein the second molding compound is applied to mechanically critical parts, e.g. in the vicinity of screwed connections or on thin parts of the molded body. Moreover, a complete part of the molded body may be realized by the fiber reinforced second molding compound, or a layered stack of the fiber reinforced second molding compound be prepared below and/or on top of the first molding compound. A stack may be applied for a part of the molded body or the molded body in complete.

A choice of the first molding compound to be used for other parts of the molded body can be done according to the fulfilment of requirements, which are important on those parts like thermo-mechanical behaviour, adhesion of the molding compound, dielectric strength and/or protection against humidity and/or hazardous gases.

In view of the implementation of a separate mesh or fibrous element to mechanically critical regions such a component can be adhered to the substrate layer or brought into a molding tool before the molding process for the preparation of the molded body is carried out. For example, a temporary adhesive material can be used for fixation in the molding tool. The mesh or fibrous element can be made of conductive or non-conductive wires or fibers. Consequently, such reinforcing parts can be integrated into the molded body by the molding process, where the elements are impregnated by molding compound.

The setup of a large molded semiconductor power package, where local mechanical reinforcement structures are implemented, will facilitate the realization of power modules with relative large molded bodies, inter alia. Consequently, business benefits are related to the advantages of corresponding semiconductor power modules and the described configurations of the semiconductor power package at least allows for one or more of the following:
- A large molded semiconductor power module can facilitate the application of larger substrates or a larger total substrate area and consequently of a larger total chip area. Consequently, a current capability of the semiconductor power module can be increased. So the customer has an economical benefit by the need of less power modules for a given electric current.
- Semiconductor power modules with a relative large molded body have the potential of a larger thermal cycling reliability due to a reduced mismatch in the thermal expansion between molding compound and substrate layer.
- A resistance with respect to humidity and hazardous gases is strongly enhanced with respect to standard power modules filled with dielectric gel, for example.
- Due to the improved mechanical stability of the molding compound, an explosion-proofness of the semiconductor power module can be enhanced as well.
- By implementing only local reinforcement structures or only local use of fiber reinforced molding compound, it is possible, to adapt advantageously the molding compound used in other parts of the molded body according to local requirements.

According to an embodiment, a semiconductor device comprises an embodiment of the described semiconductor power package and electronics which is coupled with the semiconductor power package. The semiconductor power device can also comprise a heat sink which is coupled with the substrate layer of the semiconductor power package to dissipate heat during operation. The electronics can include one or more chips or discrete devices mounted to the substrate layer.

According to an embodiment, a method for manufacturing an embodiment of the semiconductor power package comprises providing a substrate layer, providing at least one fiber and/or mesh structure, providing a pumpable substance, and molding the provided substance onto the substrate layer such that a molded body is formed having the at least one fiber and/or mesh structure forming a local reinforcement portion embedded in the molded body.

The step of providing the at least one fiber and/or mesh structure can comprise providing a first molding compound, and providing a second molding compound different form the first molding compound, wherein the first molding compound is configured to form a first molded body portion without local reinforcement and the second molding compound includes the at least one fiber and/or mesh structure and is configured to form a second molded body portion with local reinforcement.

Alternatively or additionally, the steps of providing the at least one fiber and/or mesh structure and molding the provided substance can comprise providing a separate reinforcement part including the at least one fiber and/or mesh structure, positioning the reinforcement part onto the substrate layer or placing it in the mold tool using temporary adhesive material, and molding the provided substance onto the substrate layer such that the molded body is formed having the reinforcement part embedded or covered forming a local reinforcement portion.

As a result of that the described semiconductor device and the described manufacturing method comprise or are related to produce an embodiment of the semiconductor power package, described features and characteristics of the semiconductor power package are also disclosed with respect to the semiconductor device and the manufacturing method and vice versa.

Exemplary embodiments of the semiconductor power package are explained in the following with the aid of schematic drawings and reference numbers. The figures show:
- Figure 1: embodiment of a semiconductor power package in a perspective view;
- Figures 2-3: embodiments of the semiconductor power package in respective side views;
- Figure 4: a flow chart for a method for manufacturing an embodiment of semiconductor power package.

The accompanying figures are included to provide a further understanding. It is to be understood that the embodiments shown in the figures are illustrative representations and are not necessarily drawn to scale. Identical reference numbers designate elements or components with identical functions. In so far as elements or components correspond to one another in terms of their function in different figures, the description thereof is not repeated for each of the following figures. For the sake of clarity elements might not appear with corresponding reference symbols in all figures possibly.

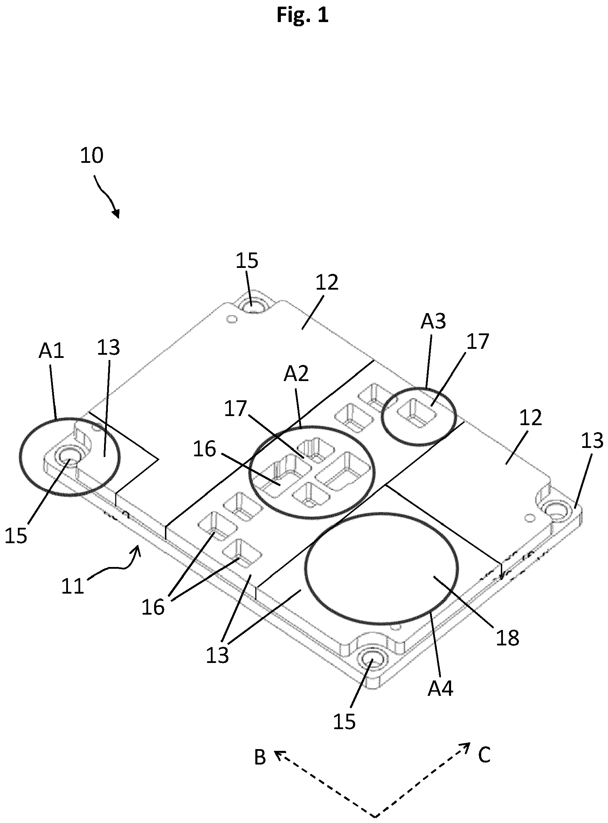

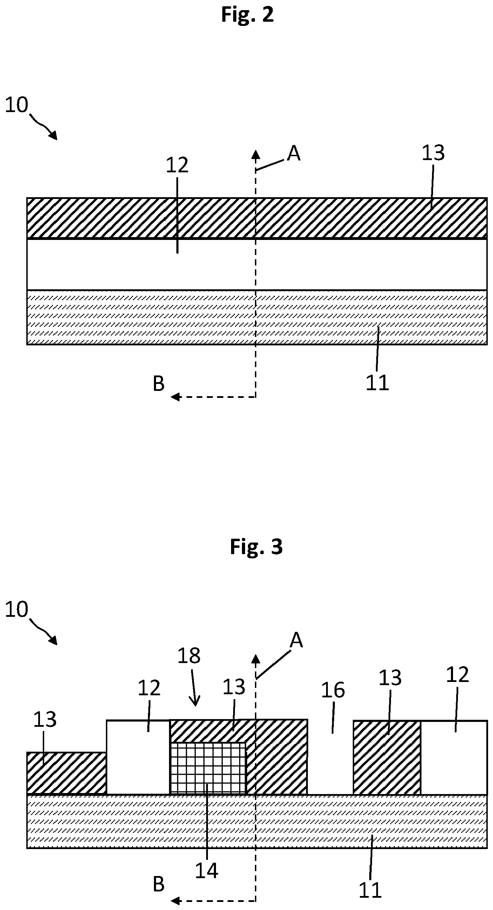

Figure 1 illustrates a perspective view of an embodiment of a semiconductor power package 10 which comprises a substrate layer 11 and a molded body coupled with the substrate layer 11. The molded body has at least one fiber and/or mesh structure forming a local reinforcement portion embedded in the molded body. According to figure 1, the semiconductor power package 10 extents in lateral directions B and C defining a main plane of extent whereas a stacking direction A is substantially perpendicular to the lateral directions B and C (see also Figs. 2 and 3). The molded body including first and second molded body portions 12 and 13 is formed on the substrate layer 11 with respect to the stacking direction A.

The term "embedded" can be interpreted in a way that there is the fiber and/or mesh structure impregnated or covered with a compound of the molded body. The fiber and/or mesh structure can also be embedded in the sense of being completely enclosed in the molded body. Alternatively, the fiber and/or mesh structure can be embedded in part. Alternatively or additionally, the corresponding mold compound may initially contain fibers.

In figure 1 the molded body of the semiconductor power package 10 has first molded body portions 12 and second molded body portions 13. According to the embodiment illustrated in figure 1 there are two first molded body portions 12 and three second molded body portions 13. The first molded body portions 12 and the second molded body portions 13 differs in that the second molded body portions 13 each comprise a fiber and/or mesh structure forming a respective part of the molded body with reinforcement. Thus, the first molded body portions 12 form a respective part of the molded body without fiber and/or mesh structure reinforcement.

The reinforcing second molded body portions 13 are associated to mechanically critical parts, e.g. in a vicinity of a screw hole 15, a recess 16, a narrow wall structure 17 and/or thin parts or a thinned area 18 of the molded body, e.g. on top or a chip or next to a screw hole. The thinned area 18 denotes a wall, a top and/or a bottom portion with a smaller wall thickness compared to a respective adjacent portion of the molded body. Accordingly, the illustrated semiconductor power package 10 comprises a first, a second, a third and a fourth reinforced area A1-A4. Further recesses 16 may not belong to a reinforced area because they do not present a mechanically critical position according to the intended application of the semiconductor power package 10, for example.

The figures 2 and 3 show further embodiments of the semiconductor power package 10 in respective side views. Figure 2 illustrates a second molded body portion 13 forming a continuous layer on top of a first molded body portion 12 which is assembled as a continuous layer on top of the substrate layer 11 with respect to the stacking direction A. Thus, the first molded body portion 12 is arranged between the second molded body portion 13 and the substrate layer 11. In other words, the second molded body portion 13 covers the first molded body portion 12. The second molded body portion 13 can be formed by a molding compound with glass and/or carbon fibers, for example. The first molded body portion 12 is formed by a molding compound without fibers, which can be filled with silicon dioxide particles, for example. The substrate layer 11 forms a baseplate of the semiconductor power package 10.

Figure 3 shows an alternative arrangement of first and second molded body portions 12 and 13, wherein one second molded body portion 13 covers an electronic unit 14 and thus realizes a reinforced protection, where the mold body has a local thinner portion. The electronic unit 14 is securely embedded between the reinforcing second molded body portion 13 and the substrate layer 11. Additionally, one or more local sections of the molded body can be prepared completely by the second molding compound. One or more sections of the first and/or second molded body portions 12 and 13 can be arranged side-by-side with respect to the lateral direction B and/or C and/or overlapping each other with respect to the stacking direction A, in part or completely, respectively.

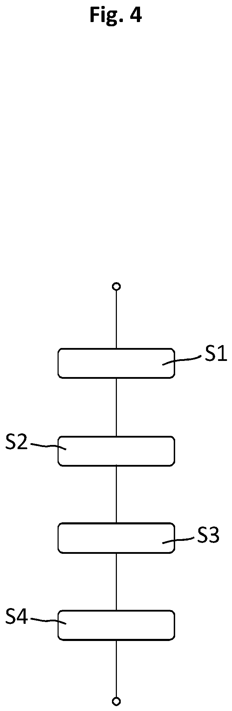

An embodiment of the semiconductor power package 10 can be manufactured according to the flow chart as illustrated in figure 4.

In a step S1 the substrate layer 11 is provided.

In a step S2 at least one fiber and/or mesh structure 11 is provided.

In a step S3 one or more pumpable substances are provided realizing a respective liquid raw material for forming the later molded body. In this respect, a pumpable substance provides a raw material which enables a corresponding molding process.

In a step S4 the provided substance is molded onto the substrate layer 11 such that the molded body is formed having the at least one fiber and/or mesh structure forming a local reinforcement portion embedded in the molded body. The molding can be done by means of transfer molding and/or compression molding and/or injection molding, for example.

The step S2 of providing the at least one fiber and/or mesh structure can comprise providing a first molding compound, and providing a second molding compound different form the first molding compound, wherein the first molding compound is configured to form a respective first molded body portion 12 without local reinforcement and the second molding compound includes the at least one fiber and/or mesh structure and is configured to form a respective second molded body portion 13 with local reinforcement.

Accordingly, the step S3 can include two molding processes of molding the first molding compound onto the substrate layer 11 and molding the second molding compound onto the substrate layer 11 and/or onto the first molding compound. Molding of the first and second molding compounds can be done simultaneously or one after the other.

Alternatively or additionally, the steps S2 and S4 of providing the at least one fiber and/or mesh structure and molding the provided substance can comprise providing a separate reinforcement part including the at least one fiber and/or mesh structure, positioning the reinforcement part onto the substrate layer 11, and molding the provided substance onto the substrate layer 11 such that the molded body is formed having the reinforcement part embedded by means of enclosing or covering and thus forming a local reinforcement portion in terms of a second molded body portion 13.

The described embodiments of the semiconductor power package 10 comprise a local improvement of the mechanical stability and enables manufacturing of a relative large transfer molded package body by fibers or elements basing on mesh and/or fibers. Reinforcements of the molded body may be specifically applied to positions, where the corresponding molding compound is exposed to large stress, as it is occurring next to the screw holes 15, or where parts of the package body have only a small cross sections or are comparably thin, as it is occurring between openings or recesses 16 for terminal mounting or above the electronic unit 14 or other semiconductor components. Nevertheless, there may be other regions in the molded body, where a reinforcement may be applied. Figure 1 shows possible positions of a large molded semiconductor power package 10 which may have an edge length of up to 100 mm or more. However, the described formation of local reinforcement is also suitable for all types of semiconductor power modules with molded bodies and for smaller sizes with an edge length of more than 50 mm or between 30 mm to 80 mm, for example.

The reinforcement structures can be implemented to the molded body basing on the local use of the fiber reinforced second molding compound. For example, the second molding compound is an epoxy molding compound, which contains a certain amount of fibers like glass fibers or carbon fibers. Consequently, the molded body of the semiconductor power package 10 comprises two different molding compounds, wherein the reinforcing second molding compound is used on mechanically critical parts. The choice of the first molding compound to be used for other parts of the molded body can be done according to the fulfilment of requirements, which are important in other part of the semiconductor power package 10 to set up a predetermined thermos-mechanical behaviour, adhesion of molding compound, dielectric strength and/or protection against humidity and hazardous gases, for example.

The reinforcement structures can also be implemented to the molded body basing on the implementation of a separate reinforcement part including a mesh and/or fibrous element to strengthen mechanically critical areas of the molded body. Such a mesh and/or fibrous element can be adhered to the substrate layer 11, for example brought into a molding tool before the molding process for preparation of the molded body is performed, for example by using a temporary adhesive material.

The proposed reinforcement structures and the corresponding second molded body portions 13 can be implemented on one hand to very local positions like a single comparably thin wall or on thinner parts above the chips as illustrated in figure 3, or next to screw parts. On the other hand, also larger parts of the molded body may be realized using reinforcement structures as indicated in figure 2. The realization of a molded body comprising two different molding compounds can be realized by two subsequent molding processes or by a single molding process with subsequent injection of the two different first and second molding compounds. For example, the use of a molding compound comprising fibers may be well suited to prepare larger module parts like the region of several openings or recesses 16 in a centre of the semiconductor power package as shown in figure 1. Otherwise a layered stack of the fiber reinforced second molding compound and the other first molding compound may be prepared locally or on the full area of the power package. The described sequence may also be vice versa, e.g. first molding of the reinforcing second molding compound, afterwards molding of the first mold compound.

In the case of the use of mesh elements attached to the substrate layer 11 or implemented into the molding tool during processing, only one homogeneous molding compound can be used for the molded body. A corresponding semiconductor power module may comprise three different components, using mesh element(s), the second molding compound with fibers, and the first molding compound without fibers.

In the case of the local use of the fiber reinforced second molding compound, on one hand completely different molding compounds can be used, where the molding compound used for other parts of the molded body or the semiconductor power package 10 may be adapted for other specific requirements, e.g. like adhesion, humidity absorption or breakdown strength. Alternatively or additionally, the semiconductor power package 10 can comply with such requirements and/or further requirements by different base material of the substrate layer 11 and/or adders or coatings to the substrate layer 11.

For example, the semiconductor power package 10 realizes a transfer molded power device, where one or more local parts of the molded body are mechanically reinforced by the use of the aforementioned fiber and/or mesh structure. The local reinforcement can contain any kind of fibers, like glass or carbon fibers or any other types of fibers. If additionally or alternatively a mesh structure is used, the mesh can be implemented as a separate module part and may comprise a metal mesh, a mesh consisting of non-conductive material or another material.

An arrangement of two different molding compounds can be done locally layered stack of bottom and top molding the compounds, layered stack of bottom and top molding compound covering complete size of the molded body, for example. The first and second molding compounds can have the same basic molding compounds only differing by filler type, e.g. fibers and/or particles). The two molding compounds can also differ by its basic resin material, ingredients and/or filler. Lateral arrangement of parts of different molding compounds is also possible.

With respect to material characteristics the described embodiments are related to molded semiconductor power packages. However, it is pointed out that the molded body and/or the substrate layer 11 can alternatively be made of polymer material in general forming a polymer body and/or the substrate layer 11. According to the described embodiments, the semiconductor power package 10 can comprise thermosetting material and the molded body includes mold compound. Thus, the semiconductor power package 10, the substrate layer 11 and/or the molded body can be made of electrically insulating material, thermoset material or thermoplastic material. The substrate layer 11 and the molded body can realize separate components or can be manufactured integrally forming one piece.

A thermoset material may e.g. be made on the basis of epoxy resin. A thermoplastic material may e.g., comprise one or more materials of the group of polyetherimide (PEI), polyether-sulfone (PES) polyphenylene-sulfide (PPS) or polyamide-imide (PAI). Thermoplastic materials melt by application of pressure and heat during molding or lamination and (reversibly) harden upon cooling and pressure release. The electrically insulating material of the molded body, the substrate layer 11 or even the semiconductor power package 10 as a whole can form an encapsulation which may comprise or be made of a polymer material. The electrically insulating material may comprise at least one of a filled or unfilled mold material, a filled or unfilled thermoplastic material, a filled or unfilled thermoset material, a filled or unfilled laminate, a fiber-reinforced laminate, a fiber-reinforced polymer laminate, and a fiber-reinforced polymer laminate with filler particles.

The embodiments shown in the Figures 1 to 4 as stated represent exemplary embodiments of the improved semiconductor power package 10 and the corresponding manufacturing method; therefore, they do not constitute a complete list of all embodiments. Actual arrangements and methods may vary from the embodiments shown in terms of semiconductor power packages, for example.

### Reference Signs

- 10: molded power module
- 11: substrate layer
- 12: first molded body portion
- 13: second molded body portion
- 14: electronic unit
- 15: screw hole
- 16: recess
- 17: narrow wall structure
- 18: area of reduced thickness

- A: stacking direction
- A1: first reinforced area
- A2: second reinforced area
- A3: third reinforced area
- A4: fourth reinforced area
- B: lateral direction
- C: lateral direction
- S(i): steps of a method for manufacturing a molded power module

## Claims

1. A semiconductor power module (10), comprising:
- a substrate layer (11), and
- a molded body coupled to the substrate layer (11) having at least one of
-- at least one fiber structure and
-- at least one mesh structure
forming a local reinforcement portion embedded in the molded body.

2. The semiconductor power module (10) according to claim 1, wherein the molded body comprises a first molding compound and a different second molding compound, the first molding compound is configured to form a first molded body portion (12) without local reinforcement and the second molding compound includes the at least one of at least one fiber structure and at least one mesh structure and is configured to form a second molded body portion (13) with local reinforcement.

3. The semiconductor power module (10) according to claim 2, wherein the second molding compound comprises at least one of glass fibers and carbon fibers.

4. The semiconductor power module (10) according to claim 2 or 3, wherein the first molding compound and the second molding compound differ from each other with respect to at least one of a respective filler and a resin material.

5. The semiconductor power module (10) according to any of the claims 2 to 4, wherein the first molded body portion (12) and the second molded body portion (13) overlap each other in part at least with respect to a lateral direction (B, C).

6. The semiconductor power module (10) according to any of the preceding claims, wherein the molded body comprises a separate reinforcement part including the at least one of a fiber structure and a mesh structure forming a second molded body portion (13) with local reinforcement.

7. The semiconductor power module (10) according to claim 6, wherein the separate reinforcement part comprises at least one of glass fibers and carbon fibers.

8. The semiconductor power module (10) according to claim 6 or 7, wherein the separate reinforcement part comprises a conductive mesh.

9. The semiconductor power module (10) according to one of the claims 6 to 8, wherein the separate reinforcement part comprises a non-conductive mesh.

10. The semiconductor power module (10) according to one of the preceding claims, wherein the molded body comprises an opening (15), a recess (16), a wall structure (17) with reduced thickness in view of an adjacent area and/or a wall area (18) with reduced thickness in view of an adjacent area and the at least one local reinforcement portion is formed adjacent to at least one of the opening (15), the recess (16), the wall area (18) and the wall structure (17).

11. The semiconductor power module (10) according to any one of the preceding claims, further comprising: an electronic unit (14) which is coupled with the substrate layer (11) and covered in the local reinforcement portion in part at least.

12. A semiconductor device, comprising:
- a semiconductor power module (10) according to one of the preceding claims, and
- electronics which is coupled with the semiconductor power module (10).

13. A method for manufacturing a semiconductor power module (10) according to one of the claims 1 to 11, comprising:
- providing a substrate layer (11),
- providing at least one of at least one fiber structure and at least one mesh structure,
- providing a substance, and
- molding the provided substance onto the substrate layer (11) such that a molded body is formed having the at least one of at least one fiber structure and at least one mesh structure forming a local reinforcement portion embedded in the molded body.

14. The method according to claim 13, wherein providing the at least one of at least one fiber structure and at least one mesh structure comprises:
- providing a first molding compound, and
- providing a second molding compound different form the first molding compound, wherein the first molding compound is configured to form a first molded body portion (12) without local reinforcement and the second molding compound includes the at least one of at least one fiber structure and at least one mesh structure and is configured to form a second molded body portion (13) with local reinforcement.

15. The method according to claim 13 or 14, wherein providing the at least one of at least one fiber structure and at least one mesh structure and molding the provided substance comprise:
- providing a separate reinforcement part including the at least one of at least one fiber structure and at least one mesh structure,
- positioning the reinforcement part relative to the substrate layer (11), and
- molding the provided substance onto the substrate layer (11) thereby forming the molded body having the reinforcement part embedded forming a local reinforcement portion.
